(19) Europäisches Patentamt

European Patent Office

Office européen des brevets

(11) **EP 1 684 415 A1**

(12) **EUROPEAN PATENT APPLICATION**

(43) Date of publication:
26.07.2006 Bulletin 2006/30

(51) Int Cl.:
*H03B 5/36* (2006.01)

(21) Application number: **06000742.4**

(22) Date of filing: **13.01.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **14.01.2005 JP 2005007292**

(71) Applicant: **Epson Toyocom Corporation**
**Saiwai-ku**
**Kawasaki-shi**
**Kanagawa 212-8513 (JP)**

(72) Inventor: **Sato, Tomio**
**Kamiina-gun**
**Nagano-ken 399-4696 (JP)**

(74) Representative: **HOFFMANN EITLE**
**Patent- und Rechtsanwälte**
**Arabellastrasse 4**
**81925 München (DE)**

(54) **Piezoelectric oscillator having symmetric inverter pair**

(57)     A piezoelectric oscillator using a pair of first and second inverter amplifiers, includes a piezoelectric vibrator inserted between the inputs of the first and second inverter amplifiers; load capacitors inserted between a ground and each of the inputs of the first and second inverter amplifiers; and resistors inserted between an input and an output of each of the first and second inverter amplifiers. In the piezoelectric oscillator, the output terminal of the first inverter amplifier is connected to the input terminal of the second inverter amplifier by a first capacitor for cutting direct current, and the input terminal of the first inverter amplifier is connected to the output terminal of the second inverter amplifier by a second capacitor for cutting direct current.

FIG. 1

EP 1 684 415 A1

Printed by Jouve, 75001 PARIS (FR)

**Description**

BACKGROUND

1. Technical Field

The present invention relates to a piezoelectric oscillator used in a mobile communication apparatus or the like which requires fast speed data communication in response to a small-sized and low noise tendency.

2. Related Art

A piezoelectric oscillator of the related art has been widely used as a clock oscillation source of a computer, and an oscillator for reference signal source in a mobile communication apparatus represented by a cellular phone or a transmitting device in terms that the piezoelectric oscillator may have a stable oscillating frequency. In particular, a piezoelectric oscillator (crystal oscillator) using crystal as a resonator has been widely used in the transmitting device or the like because the crystal has a superior resonance characteristic and high frequency stability. Recently, faster speed data communication is required in the above-described communication apparatus or the transmitting device, such that fast speed and low noise transmission is also required in a Voltage Controlled Quartz Oscillator (hereinafter, it will be referred to as VCXO). The requirement may be met by using a VCXO capable of outputting two signals having phases different from each other by 180°, i.e., Q and /Q. An oscillation circuit using an inverter suitable for an Integrated Circuit (IC), or an Quartz oscillator using an IC dedicated for fast speed data communication such as Positive Emitter Coupled Logic (PECL) and Low Voltage Differential Signaling (LVDS) in a subsequent stage of the Quartz oscillator serving as a buffer circuit, is generally known as the above-described VCXO. Hereinafter, the Quartz oscillator according to the related art used for the fast speed data communication will be described.

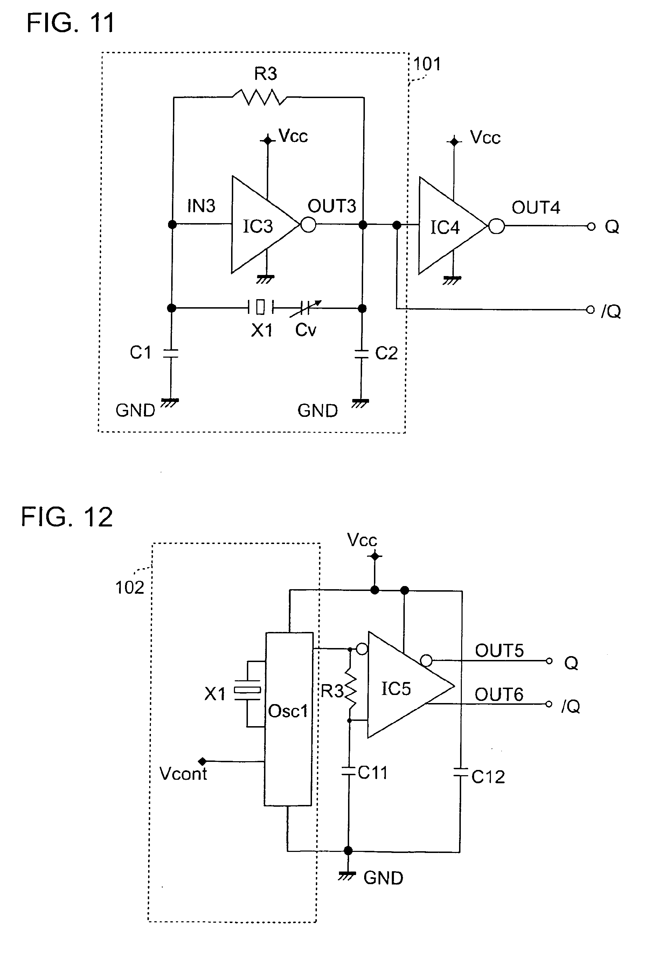

Fig. 11 shows a quartz oscillator generating two outputs having phases different from each other by 180°. The Quartz oscillator is composed of a quartz oscillation circuit 101 and a Metal Oxide Semiconductor (MOS) type inverter IC4 connected to the circuit in its subsequent stage. The quartz oscillation circuit 101 is configured such that a serial circuit composed of an Quartz vibrator X1 and a frequency adjustment circuit Cv for adjusting an oscillation frequency of the quartz oscillation circuit is connected between the input and output terminals of the inverter amplifier IC3, the serial circuit is connected in parallel with a feedback resistor R3, an input terminal IN3 of the inverter amplifier IC3 is grounded through a capacitor C1, and an output terminal OUT3 of the inverter amplifier IC3 is grounded through a capacitor C2. In addition, an operation of the quartz oscillation circuit 101 is well known, so that the description will be skipped. An output of the Quartz oscillator may have two outputs such as the output Q of the quartz oscillation circuit 101, and the output /Q having a different phase by 180° from the phase of Q obtained by inputting a portion of the circuit output /Q to the MOS type inverter IC4.

Next, Fig. 12 shows the Quartz oscillator using a differential driver IC in a subsequent stage of the quartz oscillation circuit. The Quartz oscillator has an Quartz vibrator X1, a quartz oscillation circuit 102 composed of an oscillation circuit OSC1 for oscillating the Quartz vibrator at its own oscillation frequency, and a differential driver IC5 for obtaining a differential output different from the output signal of the quartz oscillation circuit 102 by 180° in phase.

Next, outputs of the quartz oscillation circuit 102 input to the IC5 become two output signals of Q and /Q having phases different from each other by 180°, which are output from the output terminals OUT5 and OUT6 of the IC5, respectively.

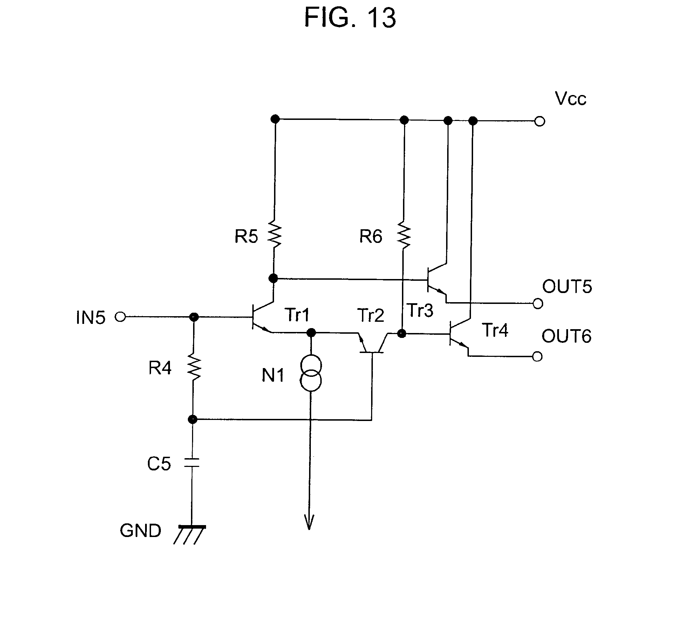

In this case, Fig. 13 shows a portion of an input part of the circuit constituting the IC5. One side between the output signals of the quartz oscillation circuit 102 input from the input terminal IN5 of the IC5, is input to a base of the transistor Tr2 of which the base is grounded by the capacitor C5, so that a signal from the collector of the transistor Tr2 is output. Since the base of the transistor Tr2 is grounded, a phase of the signal output from the collector of the transistor Tr2 has the same value as the phase of the signal input to the base of the transistor Tr2, that is, the output of the quartz oscillation circuit 102. The output signal is input to the base of the transistor Tr4 of which a collector is connected to a power source Vcc so that the output signal keeps the same phase as the output signal of the quartz oscillation circuit 102, which is then output from the emitter of the transistor Tr4 and then output from the output terminal OUT5 as an output signal Q.

Next, the other side of the output signals of the quartz oscillation circuit 102 input to the input terminal IC5 is input to the base of the transistor Tr of which the emitter is grounded, which is then output from the collector of the transistor Tr1. Since the emitter of the transistor Tr1 is grounded, a phase of the signal output from the collector of the transistor Tr1 is in an inverse relationship with a phase of the signal input to the base of the transistor Tr1. That is, a signal having a different phase from the output of the quartz oscillation circuit 102 by 180° as the input of the base of the transistor Tr1 is output. The output signal is input to the base of the transistor Tr3 of which the collector is connected to the power source Vcc so that the output signal keeps the inverse phase relationship with the output of the quartz oscillation circuit 102, which is then output from the emitter of the transistor Tr3, and then output from the output terminal OUT6 as an output signal /Q.

As such, the Quartz oscillator shown in Fig. 13 makes a phase of the output of the quartz oscillation circuit change by 180° by the transistor of the initial stage which constitutes the IC5, so that two signals having phases different from each other by 180° are output.

However, the above-described Quartz oscillator of the related art has problems as follows. In a method of using the inverter IC for making the phase inverted in a subsequent stage of the quartz oscillation circuit shown in Fig. 11, a.phase difference between both signals Q and /Q deviates slightly from 180° in the output signal Q due to a delay by an operation time of the inverter IC. In addition, in a method of connecting the IC by means of a differential driver or the like in a subsequent stage of the quartz oscillation circuit shown in Fig. 12, a transistor of which a base is grounded needs to be inserted in one end of the differential driver in order to take out two signals having phases different from each other by 180°, and the phase difference deviates from 180° due to the operation of the transistor of which the base is grounded.

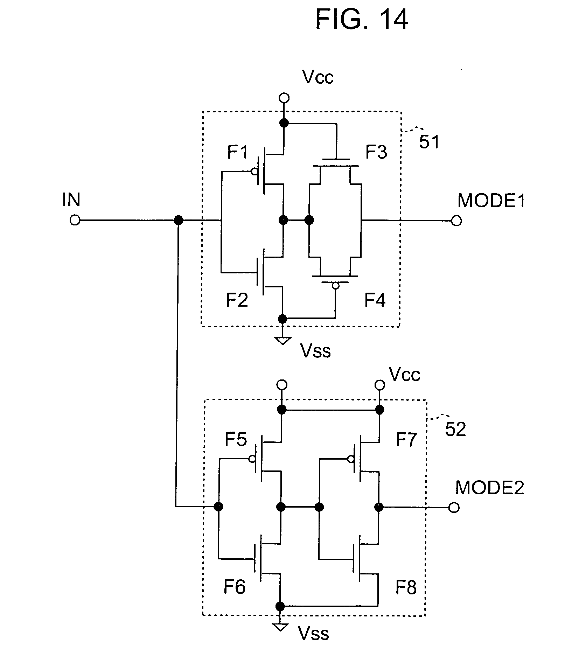

Accordingly, a method is disclosed in the JP-A-9-172369, which takes out two output signals having phases different from each other by 180° by making the signals pass through a positive emitter coupled logic (PECL) buffer circuit composed of an input stage using a transistor circuit at a subsequent end of the oscillation circuit, a balanced circuit, and an output stage. According to the above-described Publication, the input stage of the PECL buffer circuit is composed of a first circuit 51 and a second circuit 52. The first circuit 51 is composed of a gate grounded amplification circuit connected to a subsequent stage of the source grounded amplification circuit composed of a CMOS structure using transistors like FETs shown in Fig. 14, and the second circuit 52 is composed of two stages of source grounded amplification circuits composed of the same CMOS structure as the first circuit 51. As a result, an output signal MODE1 from the first circuit 51 has a phase inverted from the phase of an input signal of the first circuit 51 by the CMOS inverter circuit for phase inversion and the gate grounded amplification circuit as the same phase amplifier at the next stage. In addition, an output signal MODE2 from the second circuit 52 passes through the CMOS inverter circuit for phase inversion by two stages, so that the phase inversion occurs two times so as to output the output signal with the same phase as the input signal of the second circuit 52. According to the above-described operations, two output signals having phases different from each other by 180° may be obtained. The two signals pass through the balance circuit and the output stage so as to maintain the phase states different from each other by 180° and are output from the PECL buffer circuit.

However, the above-described publication is an invention related to a buffer circuit, which is connected to the subsequent stage of the signal source because the buffer circuit should be connected to the subsequent stage in the quartz oscillation circuit requiring two signals having phases different from each other by 180°. Accordingly, the dimension of the buffer circuit increases the dimension of the Quartz oscillator of the related art, so that it is difficult to make it small-sized.

## SUMMARY

An advantage of some aspects of invention is that it provides a piezoelectric oscillator used in a mobile communication apparatus or the like which requires fast speed data communication, which may deal with the small-sized and low noise tendency and take out two output signals having phases different from each other by 180° from the oscillation circuit without using a buffer circuit.

According to an aspect of the invention, an oscillation circuit is provided as one for obtaining two output signals having phases different from each other by 180° from the piezoelectric oscillator configured such that a pair of CMOS inverters are connected by a capacitor to cross each other at an inclined manner, and a piezoelectric vibrator and a frequency adjustment circuit are inserted between inputs of the pair of CMOS inverters, and the inputs of the pair of CMOS inverters are grounded through the capacitors, respectively, thereby constituting the oscillation circuit.

The piezoelectric oscillator according the invention is composed of an oscillation circuit formed by connecting a pair of CMOS inverter circuits crossed in inclined manner to each other, so that two signals having phases different from each other by 180° may be taken out by the oscillation circuit without using a buffer circuit such as LVDS (Small-amplitude Differential Signal Interface, Low Voltage Differential Signaling) or PECL IC. In addition, a receiver driver having a general structure of differential amplifier may be used in a subsequent stage of the circuit of the invention, so that a low noise oscillator in which the same phase noise occurring within the oscillation circuit is removed may be provided.

## BRIEF DESCRIPTION.OF THE DRAWINGS

The invention will be described with reference to the accompanying drawings, wherein like numbers reference like elements.

Fig. 1 is a quartz oscillation circuit view illustrating an embodiment of the invention.

Fig. 2 is a view illustrating oscillation frequency versus circuit capacity and negative resistance resulted from the simulation of the quartz oscillation circuit of Fig. 1.

Fig. 3 is a view illustrating an output waveform in the quartz oscillation circuit of Fig. 1.

Fig. 4 is a view illustrating a variable capacity versus amount of frequency change in the quartz oscillation circuit of Fig. 1.

Fig. 5 is view illustrating a quartz oscillation circuit in accordance with a second embodiment of the invention.

Fig. 6 is a view illustrating simulation results of oscillation frequency versus circuit capacity and negative resistance in the quartz oscillation circuit of Fig. 5.

Fig. 7 is a view illustrating an output waveform in the quartz oscillation circuit of Fig. 5.

Fig. 8 is a view illustrating a quartz oscillation circuit in accordance with a third embodiment of the invention.

Fig. 9 is a view illustrating the simulation results of load capacity versus circuit capacity and negative resistance in the quartz oscillation circuit of Fig. 8.

Fig. 10 is a view illustrating an output waveform in the quartz oscillation circuit of Fig. 8.

Fig. 11 is a view illustrating a structure of a Quartz oscillator according to the related art using a MOS type inverter IC.

Fig. 12 is a view illustrating a structure of a Quartz oscillator according to the related art using a differential driver IC.

Fig. 13 is a detailed view illustrating an initial stage of the differential driver IC of Fig. 12.

Fig. 14 is a view illustrating a structure of a Quartz oscillator according to the related art using a PECL buffer.

## DESCRIPTION OF EXEMPLARY EMBODIMENTS

Hereinafter, the invention will be described in detail based on the illustrated embodiments.

In addition, the same constituting members as those shown in the related art are denoted by the same numbers, so that the description will be omitted.

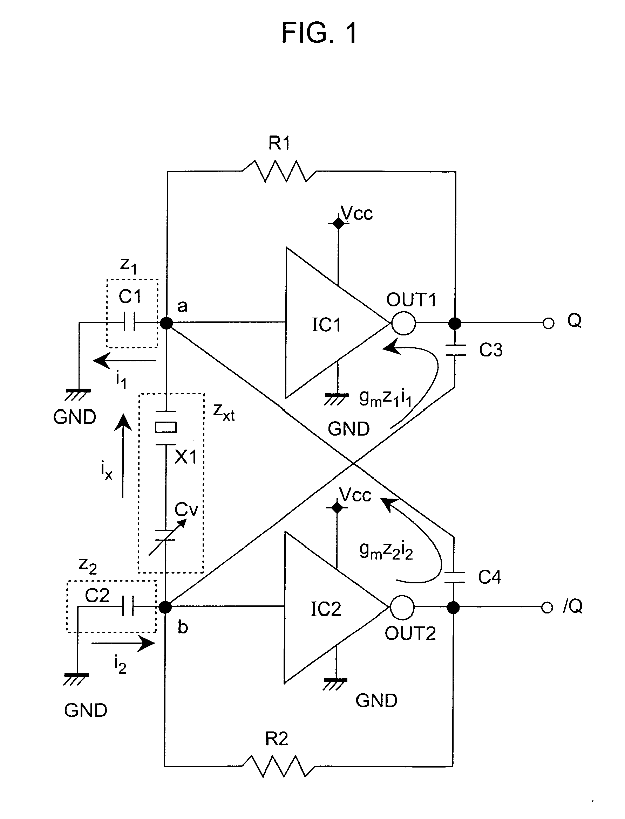

Fig. 1 is a view illustrating a circuit of the Quartz oscillator in accordance with an embodiment of the invention. The Quartz oscillator includes a first CMOS inverter circuit IC1, and a second CMOS inverter circuit IC2 same as the first CMOS inverter circuit IC1, which cross each other at an inclined manner. An input of the first CMOS inverter circuit IC1 and an output of the second CMOS inverter circuit IC2 are connected to each other by a capacitor C4 for cutting direct current, and an output of the first CMOS inverter circuit IC1 and an input of the second CMOS inverter circuit IC2 are connected to each other by a capacitor C3 for cutting direct current. In addition, the input of the first CMOS inverter circuit IC1 and the input of the second CMOS inverter circuit IC2 are connected to each other by a serial circuit composed of an Quartz vibrator X1 and a variable capacitor Cv as a frequency adjustment circuit. In addition, the input of the first CMOS inverter circuit IC1 is grounded through a load capacitor C1 while being connected to the output of the first CMOS inverter circuit IC1 by a resistor R1. The input of the second CMOS inverter circuit IC2 is grounded through a load capacitor C2 while being connected to the output of the second CMOS inverter circuit IC2 by a resistor R2. As such, the Quartz oscillator includes two quartz oscillation circuits using the CMOS inverter circuit. In addition, the capacities C3 and C4 for cutting direct current have the same values as each other, and the resistors R1 and R2 have the same values as each other.

Hereinafter, an operation principle of the quartz oscillation circuit with the above-mentioned construction will be described. Referring to the circuit shown in Fig. 1, impedances of the load capacitors C1 and C2 are denoted as C1 $= z_1$ and C2 $= z_2$, respectively, an impedance of the serial circuit composed of the Quartz vibrator X1 and the variable capacitor Cv for frequency adjustment is denoted as $z_{xt}$, and currents flowing in the impedances $z_1$, $z_2$, and $z_{xt}$ are denoted as $i_1$, $i_2$, and $i_x$, respectively, which may be applied to nodes a and b by Kirchhoff's law, such that the following equations (1) to (3) are obtained:

$$i_1 = i_x + g_m z_2 i_2 \qquad (1)$$

$$i_2 = i_x + g_m z_1 i_1 \qquad (2)$$

$$z_2 i_2 + z_{xt} i_x + z_1 i_1 = 0 \qquad (3)$$

In the above equations, $g_m$ denotes a mutual conductance of the inverter ICs. When the equations (1) and (2) are modified and substituted for the equation (3), the following equation is obtained:

$$z_{xt} + \frac{1}{1 - g_m^2 z_1 z_2}(z_1 + z_2 + 2g_m z_1 z_2) = 0 \qquad (4)$$

In this case, when $z_1$ and $z_2$ are substituted by the same capacitance Ca and then applied to the equation (4), the following equations are obtained:

$$z_1 = z_2 = \frac{1}{jwc_a} \qquad (5)$$

$$z_{xt} + \frac{2}{1 + \frac{g_m^2}{w^2 c_a^2}}\left(\frac{1}{jwc_a} - \frac{g_m}{w^2 c_a^2}\right) = z_{xt} + R_c + \frac{1}{jwc_2} = 0 \qquad (6)$$

In this case, an impedance Rc and a capacitance component Cc of the circuit seen from the Quartz vibrator X1 are obtained as follows:

$$R_c = -\frac{2g_m}{w^2 c_a^2 + g_m^2}, \quad \frac{1}{c_c} = \frac{2}{c_a}\frac{1}{1 + \frac{g_m^2}{w^2 c_a^2}} \qquad (7)$$

As it is widely known in the art, an oscillation condition of the quartz oscillation circuit essentially requires that the impedance of the circuit seen from the Quartz vibrator be composed of a negative resistance component and a capacitance component. The circuit of Fig. 1 using a pair of the CMOS inverter circuits acts as a quartz oscillation circuit because of meeting the oscillation condition from the equation (7). In addition, the circuit of Fig. 1 is composed of two quartz oscillation circuits using two CMOS inverter circuits as described above, and a portion of each output of the CMOS inverter circuits is taken out as the oscillation output. As a result, an input of one side of the CMOS inverter circuits becomes a portion of the output of the other side of the CMOS inverter circuits, so that the output signals of the CMOS inverter circuits are signals of Q and /Q having phases different from each other by 180°.

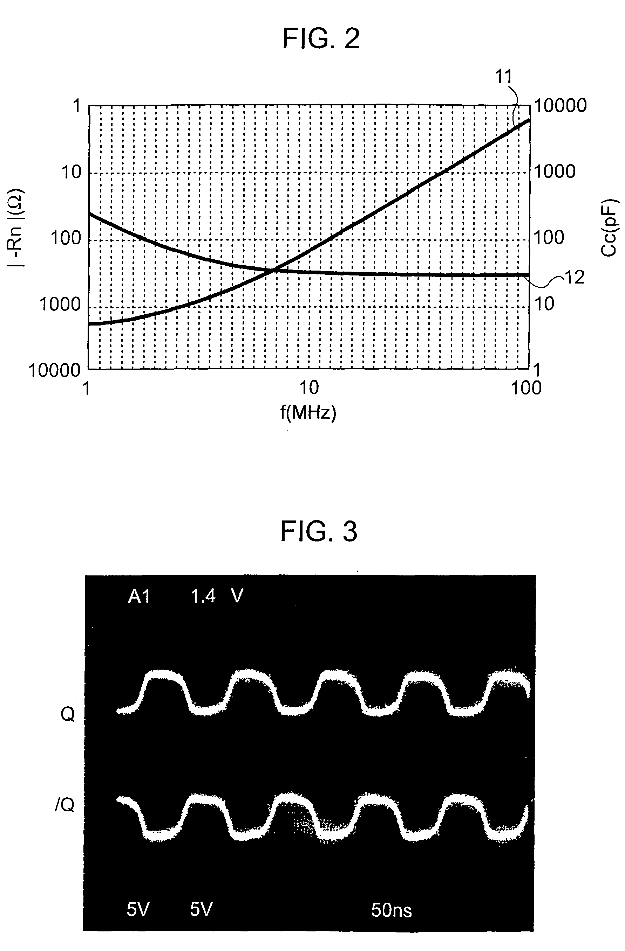

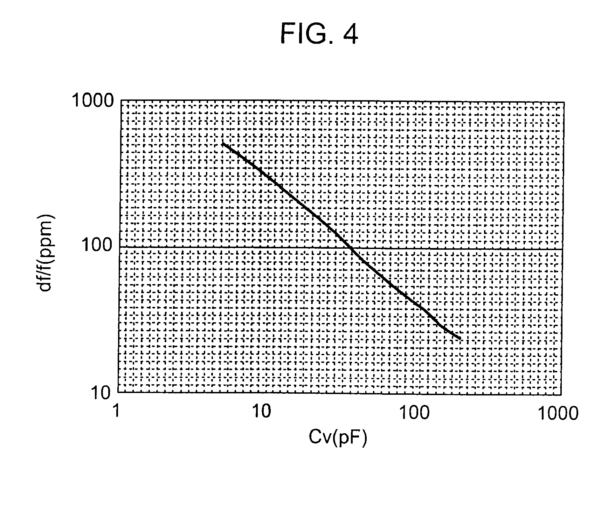

Next, Figs. 2 to 4 show simulation and actual measurement results using the oscillation circuit of Fig. 1 when circuit constants are set as R1 = R2 = 20 kΩ, C1 = C2 = 56 pF, C3 = C4 = 6 pF, a resonance frequency of the quartz oscillation unit as 10 MHz and the CMOS inverter circuits IC1 and IC2 are general-purpose CMOS inverter ICs. The characteristic curve 11 of Fig. 2 shows the negative resistance of the circuit with respect to the oscillation frequency, the characteristic curve 12 of Fig. 2 shows the circuit capacitance with respect to the oscillation frequency, Fig. 3 shows an output waveform in the quartz oscillation circuit of the present embodiment, and Fig. 4 shows a frequency variable characteristic in the quartz oscillation circuit. Referring to Figs. 2 and 3, the present circuit meets the oscillation condition in terms that the negative resistance Rn is about -110 Ω and the circuit capacitance is 20 pF at the oscillation frequency of 10 MHz, so that phases different from each other by 180° are also obtained from the outputs Q and /Q of the quartz oscillation circuit at the time of oscillation. In addition, referring to Fig. 4, the amount of change in frequency df/f becomes about 500 ppm when the frequency variable capacitance Cv is changed in a range of 5 pF to 200 pF, so that the present oscillation circuit sufficiently acts as the VCXO capable of varying the frequency by means of an external voltage.

As such, the pair of inverter circuits are connected to cross each other at an inclined manner to form the quartz oscillation circuit, so that the two oscillation outputs may keep their phase difference of 180°, which thus provides the piezoelectric oscillator adapted for fast speed data communication. In addition, a new buffer circuit or the like for making the phase difference of the oscillator outputs different from each other by 180° is unnecessary, such that the small-sized oscillator may be implemented, and a receiver driver having a general differential amplifier structure may be used in the subsequent stage of the quartz oscillation circuit, such that a low noise oscillator in which the same phase noise occurring in the oscillation circuit is removed may be implemented.

The CMOS inverters are used for the inverter circuit in the present embodiment, however, the invention is not limited thereto but may employ other structures like LVPECL or LVDS.

Second embodiment

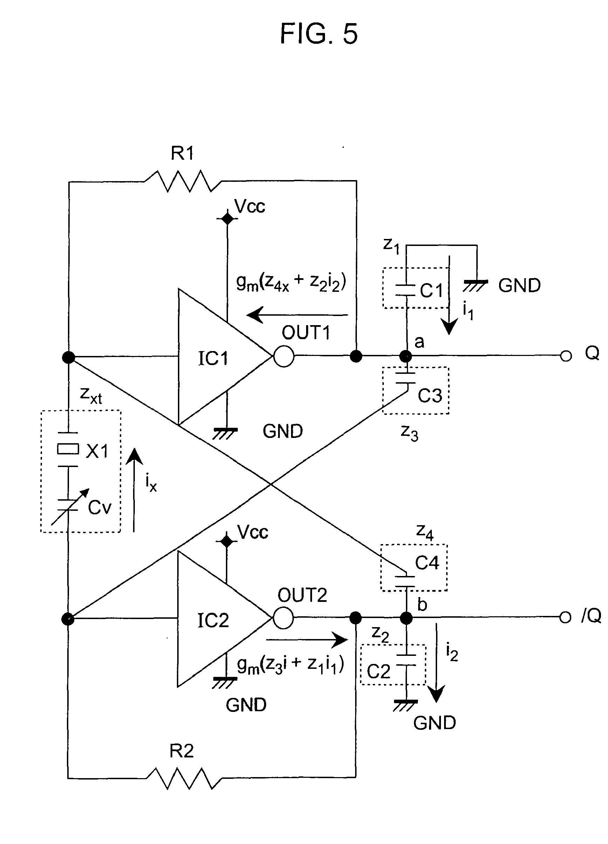

Fig. 5 is a view illustrating a circuit of the Quartz oscillator in accordance with a second embodiment of the invention. The Quartz oscillator includes a first CMOS inverter circuit IC1, and a second CMOS inverter circuit IC2 same as the first CMOS inverter circuit IC1, which cross each other at an inclined manner. An input of the first CMOS inverter circuit IC1 and an output of the second CMOS inverter circuit IC2 are connected to each other by a capacitor C4 for cutting direct current, and an output of the first CMOS inverter circuit IC1 and an input of the second CMOS inverter circuit IC2 are connected to each other by a capacitor C3 for cutting direct current. In addition, the input of the first CMOS inverter circuit IC1 and the input of the second CMOS inverter circuit IC2 are connected to each other by a serial circuit composed of an Quartz vibrator X1 and a variable capacitor Cv as a frequency adjustment circuit. In addition, the output of the first CMOS inverter circuit IC1 is grounded through a load capacitor C1 while being connected to the input of the first CMOS inverter circuit IC1 by a resistor R1. The output of the second CMOS inverter circuit IC2 is grounded through a load capacitor C2 while being connected to the input of the second CMOS inverter circuit IC2 by a resistor R2. As such, the Quartz oscillator includes two quartz oscillation circuits using the CMOS inverter circuit. In addition, the capacities C3 and C4 for cutting direct current have the same values as each other, and the resistors R1 and R2 have the same values as each other.

Hereinafter, an operation principle of the above-described quartz oscillation circuit will be described. Referring to the circuit shown in Fig. 4, impedances of the load capacitors C1 and C2 are denoted as $C1 = z_1$ and $C2 = z_2$, respectively, an impedance of the serial circuit composed of the Quartz vibrator X1 and the variable capacitor Cv for frequency adjustment is denoted as $Z_{xt}$, and currents flowing in the impedances $z_1$, $z_2$, and $z_{xt}$ are denoted as $i_1$, $i_2$, and $i_x$, respectively, which may be applied to the nodes a and b by the Kirchhoff's law, so that the equations (8) to (10) are obtained.

$$i_1 = (1 + g_m z_4) i_x + g_m z_2 i_2 \qquad (8)$$

$$i_2 = (1 + g_m z_3) i_x + g_m z_1 i_1 i_x \qquad (9)$$

$$z_1 i_1 + (z_3 + z_{xt} + z_4) i_x + z_2 i_2 = 0 \qquad (10)$$

In the above equations, $g_m$ denotes a mutual conductance of the inverter ICs. When the equations (8) and (9) are modified and substituted for the equation (10), the following equation is obtained:

$$z_{xt} + z_3 + z_4 + \frac{1}{1 - g_m^2 z_1 z_2} \left\{ z_1 + z_2 + g_m (z_4 z_1 + z_3 z_2 + 2 z_1 z_2) + g_m^2 z_1 z_2 (z_3 + z_4) \right\} = 0 \qquad (11)$$

In this case, when $z_1 = z_2 = z_b$, and $z_3 = z_4 = z_a$ are applied to the equation (11), the following equations are obtained:

$$z_1 = z_2 = z_b \ , z_3 = z_4 = z_a \qquad (12)$$

$$z_{xt} + 2z_b + \frac{2}{1-g_m^2 z_a^2}\left\{z_a + g_m(z_a z_b + z_a^2) + g_m^2 z_b z_a^2\right\}= 0 \qquad (13)$$

In addition, $z_a$ and $z_b$ are impedances of capacitances Ca and Cb, respectively, which are then applied to the equation (13).

$$z_a = \frac{1}{jwc_a} \ , \ z_b = \frac{1}{jwc_b} \qquad (14)$$

$$z_{xt} - \frac{2g_m}{w^2 c_a^2 + g_m^2}\left(\frac{c_a}{c_b}+1\right) \ , \ \frac{1}{c_c} = 2\left\{\frac{1}{c_b} + \frac{1}{w^2 c_a^2 + g_m^2}\left(w^2 c_a - \frac{g_m^2}{c_b}\right)\right\} \qquad (15)$$

In this case, an impedance Rc and a capacitance component Cc seen from the Quartz vibrator X1 are obtained as follows:

$$R_c = -\frac{2g_m}{w^2 c_a^2 + g_m^2}\left(\frac{c_a}{c_b}+1\right) \ , \ \frac{1}{c_c} = 2\left\{\frac{1}{c_b} + \frac{1}{w^2 c_a^2 + g_m^2}\left(w^2 c_a - \frac{g_m^2}{c_b}\right)\right\} \qquad (16)$$

As described above, an oscillation condition of the quartz oscillation circuit essentially requires that the impedance of the circuit seen from the Quartz vibrator be composed of a negative resistance component and a capacitance component. The circuit of the second embodiment shown in Fig. 5 acts as a quartz oscillation circuit because of meeting the oscillation condition from the equation (16). In addition, the circuit of Fig. 5 is composed of the quartz oscillation circuit using two CMOS inverter circuits, and the output of the quartz oscillation circuit is taken out as the oscillation output from a portion of each output of the CMOS inverter circuits. As a result, an input of one side of the CMOS inverter circuits becomes a portion of the output of the other side of the CMOS inverter circuits, so that the output signals of the CMOS inverter circuits are signals of Q and /Q having phases different from each other by 180°.

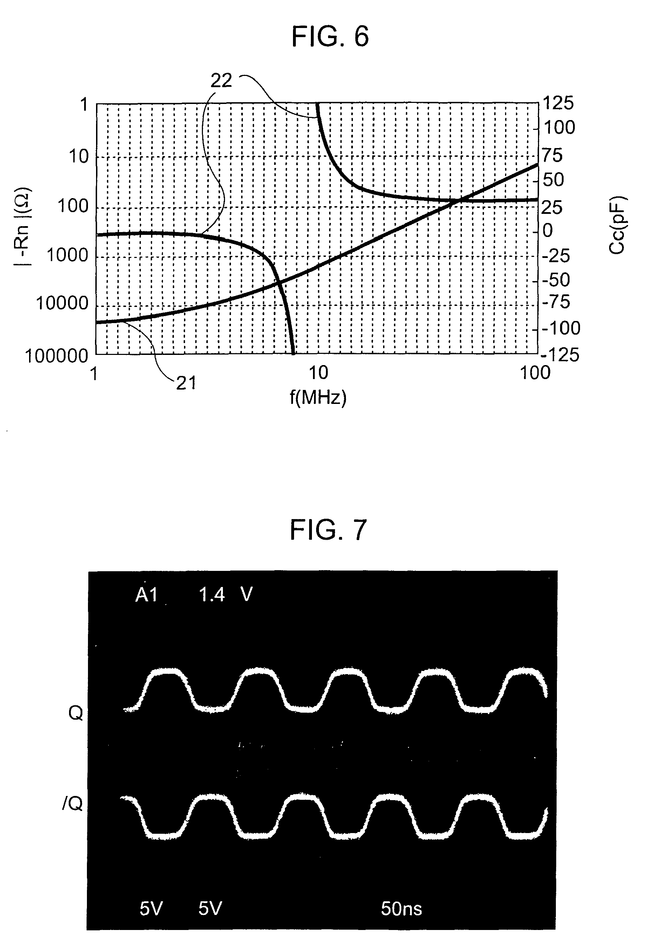

Next, Figs. 6 and 7 show simulation and actual measurement results using the oscillation circuit of Fig. 5 when circuit constants are set as R1 = R2 = 20 kΩ, C1 = C2 = 56 pF, C3 = C4 = 6 pF and the CMOS inverter circuits IC1 and IC2 are general-purpose CMOS inverter ICs.

The characteristic curve 21 of Fig. 6 shows the negative resistance of the circuit with respect to the oscillation frequency, the characteristic curve 22 of Fig. 6 shows the circuit capacitance with respect to the oscillation frequency, and Fig. 7 shows an output waveform in the quartz oscillation circuit of the present embodiment. Referring to Figs. 6 and 7, the present circuit of Fig. 5 meets the oscillation condition in terms that the negative resistance is about - 1000 Ω and the circuit capacitance is about 100 pF at the oscillation frequency of 10 MHz, such that phases different from each other by 180° are also obtained from the outputs Q and /Q of the quartz oscillation circuit at the time of oscillation.

As such, the pair of inverter circuits are connected to cross each other at an inclined manner to form the quartz oscillation circuit, such that the two oscillation outputs may completely keep their phase difference of 180°.

Third embodiment

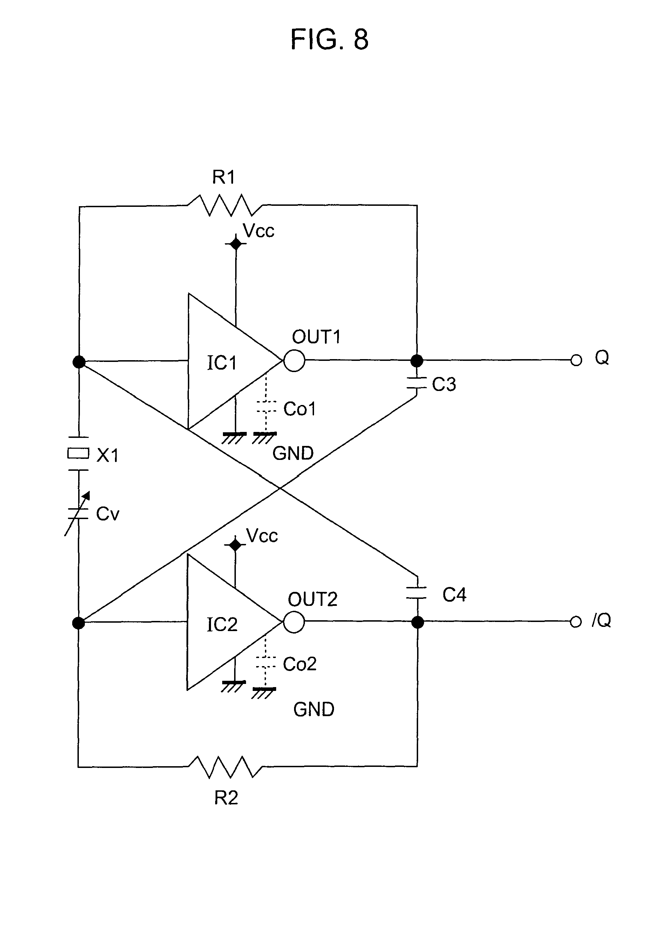

Fig. 8 is a view illustrating a circuit of the Quartz oscillator in accordance with a third embodiment of the invention. The Quartz oscillator includes a first CMOS inverter circuit IC1, and a second CMOS inverter circuit IC2 same as the first CMOS inverter circuit IC1, which cross each other at an inclined manner. An input of the first CMOS inverter circuit IC1 and an output of the second CMOS inverter circuit IC2 are connected to each other by a capacitor C4 for cutting direct current, and an output of the first CMOS inverter circuit IC1 and an input of the second CMOS inverter circuit IC2 are connected to each other by a capacitor C3 for cutting direct current. In addition, the input of the first CMOS inverter circuit IC1 and the input of the second CMOS inverter circuit IC2 are.connected to each other by a serial circuit composed of an Quartz vibrator X1 and a variable capacitor Cv serving as a frequency adjustment circuit. In addition, the output of the first CMOS inverter circuit IC1 and the input of the first CMOS inverter circuit IC1 are connected through a feedback resistor R1, and the output of the second CMOS inverter circuit IC2 and the input of the second CMOS inverter circuit IC2 are connected by a resistor R2. In addition, the capacities C3 and C4 for cutting direct current have the same values as each other, and the resistors R1 and R2 have the same values as each other.

Referring to the above-described circuit shown in Fig. 8, the impedance of the circuit seen from the Quartz vibrator X1 is same as the extremely small capacitance Ca of the equation (16), because the load capacitance of the circuit becomes internal load capacitances Co1 and Co2 of the CMOS inverter IC that are extremely small enough to be negligible as compared to the load capacitances C1 and C2 of Fig. 5. In the equation (16), the circuit shown in Fig. 8 acts as the quartz oscillation circuit in terms that it meets the oscillation condition hardly having a change in the impedance of the circuit even when the capacitance Cb is made to be small.

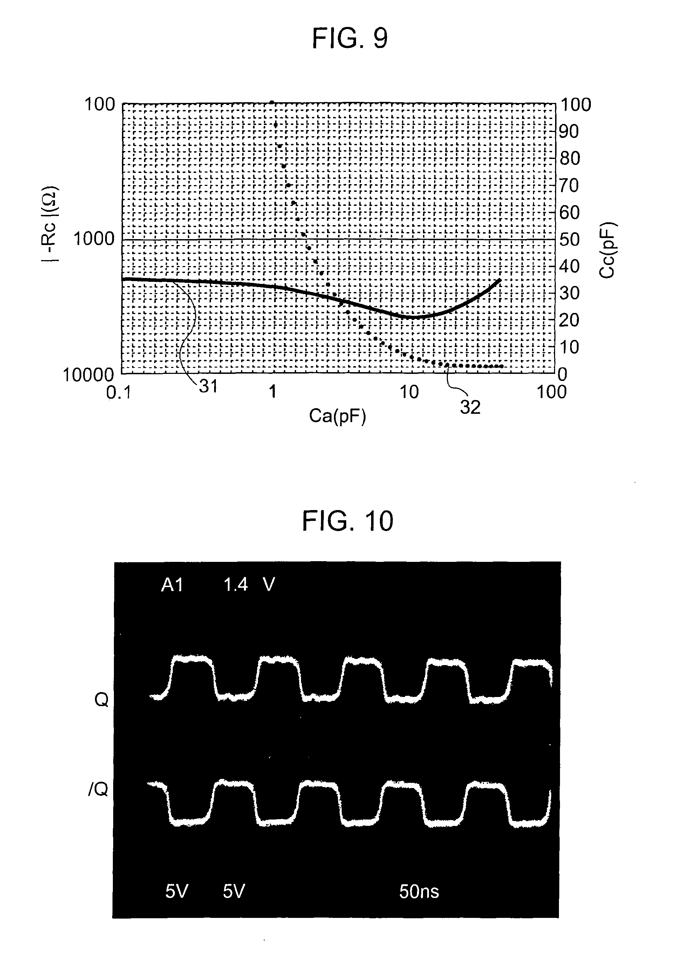

Next, Figs. 9 and 10 show simulation and actual measurement results using the oscillation circuit of Fig. 8 when circuit constants are set as R1 = R2 = 20 kΩ, C3 = C4 = 6 pF and the CMOS inverter circuits IC1 and IC2 are general-purpose CMOS inverter ICs. The characteristic curve 31 of Fig. 9 shows the negative resistance of the circuit with respect to the load capacitance Ca, the characteristic curve 32 of Fig. 9 shows the circuit capacitance with respect to the load capacitance Ca, and Fig. 10 shows an output waveform in the quartz oscillation circuit of the present embodiment. Referring to Figs. 9 and 10, the present circuit of Fig. 8 meets the oscillation condition in terms that the negative resistance is about -2000 Ω according to the change of the load capacitance Cb and the circuit is capacitive, such that phases different from each other by 180° are obtained from the outputs Q and /Q of the quartz oscillation circuit at the time of oscillation.

As such, the pair of inverter circuits are connected to cross each other at an inclined manner to constitute the quartz oscillation circuit, such that the two oscillation outputs may completely keep their phase difference of 180°.

The voltage controlled Quartz oscillator has been described in the above-described embodiments, however, the invention is not limited thereto but may be applied to a temperature compensated type or thermostat controlled type Quartz oscillator, and a piezoelectric oscillator using a piezoelectric vibrator other than the Quartz, such that the same effect may be obtained.

## Claims

1. A piezoelectric oscillator using a pair of first and second inverter amplifiers, comprising:

   a piezoelectric vibrator inserted between gate inputs of the first and second inverter amplifiers;
   load capacitors inserted between a ground and each of the gate inputs of the first and second inverter amplifiers; and
   resistors inserted between an input and an output of each of the first and second inverter amplifiers,

   wherein the output terminal of the first inverter amplifier is connected to the input terminal of the second inverter amplifier by a first capacitor for cutting direct current, and the input terminal of the first inverter amplifier is connected to the output terminal of the second inverter amplifier by a second capacitor for cutting direct current.

2. A piezoelectric oscillator using a pair of first and second inverter amplifiers, comprising:

   a piezoelectric vibrator inserted between gate inputs of the first and second inverter amplifiers;
   load capacitors inserted between a ground and each of gate outputs of the first and second inverter amplifiers; and
   resistors inserted between an input and an output of each of the first and second inverter amplifiers,

   wherein the output terminal of the first inverter amplifier is connected to the input terminal of the second inverter amplifier by a first capacitor for cutting direct current, and the input terminal of the first inverter amplifier is connected to the output terminal of the second inverter amplifier by a second capacitor for cutting direct current.

3. A piezoelectric oscillator using a pair of first and second inverter amplifiers, comprising:

   a piezoelectric vibrator inserted between gate inputs of the first and second inverter amplifiers; and
   resistors inserted between an input and an output of each of the first and second inverter amplifiers,

   wherein the output terminal of the first inverter amplifier is connected to the input terminal of the second inverter amplifier by a first capacitor for cutting direct current, and the input terminal of the first inverter amplifier is connected to the output terminal of the second inverter amplifier by a second capacitor for cutting direct current.

4. The piezoelectric oscillator according to Claim 1, further comprising:

a frequency adjustment unit inserted in serial with the piezoelectric vibrator.

5. The piezoelectric oscillator according to Claim 1,
wherein the first and second capacitors for cutting direct current have the same values as each other, the load capacitors have the same values as each other, and the resistors have the same values as each other.

# FIG. 1

# FIG. 2

# FIG. 3

## FIG. 4

# FIG. 5

## FIG. 6

## FIG. 7

# FIG. 8

## FIG. 9

## FIG. 10

## FIG. 11

R3

Vcc

IN3    IC3    OUT3

Vcc

IC4    OUT4    ○ Q

○ /Q

X1    Cv

C1    C2

GND    GND

101

## FIG. 12

Vcc

102

X1    Osc1    R3    IC5    OUT5    ○ Q

OUT6    ○ /Q

Vcont

C11    C12

GND

# FIG. 13

# FIG. 14

**European Patent Office**

## EUROPEAN SEARCH REPORT

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 3 890 580 A (KUHN, JR. ET AL) 17 June 1975 (1975-06-17) * column 4, lines 6-13 * * figure 2 * ----- | 1-5 | INV. H03B5/36 |
| A | US 3 613 029 A (PETER G. BARTLETT) 12 October 1971 (1971-10-12) * figure 1 * ----- | 1-5 | |
| A | FOX ELECTRONICS: "Quartz Crystal Design Notes" INTERNET ARTICLE, [Online] 2004, XP002376066 Retrieved from the Internet: URL:http://www.foxonline.com/pdfs/xtaldesi gnnotes.pdf> [retrieved on 2006-04-05] * page 105 * ----- | 1,2 | |
| | | | TECHNICAL FIELDS SEARCHED (IPC) H03B H03K G06F |

The present search report has been drawn up for all claims

| Place of search | Date of completion of the search | Examiner |
|---|---|---|
| Munich | 10 April 2006 | Robinson, V |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.................................................................................

& : member of the same patent family, corresponding document

EPO FORM 1503 03.82 (P04C01)

EP 1 684 415 A1

## ANNEX TO THE EUROPEAN SEARCH REPORT
## ON EUROPEAN PATENT APPLICATION NO.

EP 06 00 0742

This annex lists the patent family members relating to the patent documents cited in the above-mentioned European search report.
The members are as contained in the European Patent Office EDP file on
The European Patent Office is in no way liable for these particulars which are merely given for the purpose of information.

10-04-2006

| Patent document cited in search report | | Publication date | Patent family member(s) | Publication date |
|---|---|---|---|---|
| US 3890580 | A | 17-06-1975 | NONE | |
| US 3613029 | A | 12-10-1971 | NONE | |